# EUROPÄISCHE PATENTSCHRIFT

(11) **EP 1 891 670 B1**
(45) Veröffentlichungstag und Bekanntmachung des Hinweises auf die Patenterteilung: **03.02.2010**
(21) Anmeldenummer: 06763447.7
(22) Anmeldetag: 01.06.2006
(51) Int. Cl.: H01L 21/768

(54) **Verfahren zur Erzeugung von vertikalen elektrischen Kontaktverbindungen in Halbleiterwafern**
Method for producing vertical electrical contact connections in semiconductor wafers
Procédé de production de trous de liaison électrique verticaux dans des tranches de semi-conducteurs

(30) Priorität: 01.06.2005 DE 102005026131; 31.08.2005 DE 102005042072
(43) Veröffentlichungstag der Anmeldung: 27.02.2008
(73) Patentinhaber: Forschungsverbund Berlin e.V., 12489 Berlin (DE)
(72) Erfinder: KRÜGER, Olaf, 12524 Berlin (DE); WÜRFL, Joachim, 15738 Zeuthen (DE); SCHÖNE, Gerd, 12524 Berlin (DE)
(74) Vertreter: Hengelhaupt, Jürgen
(86) Internationale Anmeldenummer: PCT/EP2006/062824
(87) Internationale Veröffentlichungsnummer: WO 2006/128898

(56) Entgegenhaltungen:
- EP-A- 0 926 723
- US-A- 4 964 212
- US-A1- 2005 104 228

## Beschreibung

Die Erfindung betrifft ein Verfahren zur Erzeugung von vertikalen elektrischen Kontaktverbindungen (Mikro-Vias, via = vertical interconnect access) in Halbleiterwafern zur Herstellung von Halbleiter-Bauelementen, das heißt von Kontakten auf der Wafer-Vorderseite durch den Halbleiter-Wafer hindurch zur Wafer-Rückseite.

Die weitere fortschreitende Miniaturisierung elektronischer Bauelemente erfordert eine immer kompaktere Integration in die Peripherie. Kurze vertikale Verbindungen stellen einen effizienten Weg der elektrischen Kontaktierung dar. Außerdem ist es aus physikalischen Gründen erforderlich, zur Erhöhung der Verstärkung und der maximal pro Chip verfügbaren Ausgangsleistung von Hochleistungstransistoren eine elektrisch leitende Verbindung mit niedriger Induktivität zwischen den Source-Kontakten auf der Vorderseite und der Masseelektrode auf der Rückseite herzustellen. Dies lässt sich jedoch technologisch nicht immer leicht realisieren.

Elektrisch aktives GaN-Material (Galliumnitrid) steht derzeit praktisch nicht als einkristallines Wafermaterial zur Verfügung und wird daher epitaktisch auf Substratmaterialien wie zum Beispiel SiC-Wafern (Siliciumcarbid) gewachsen. SiC zeichnet sich durch eine sehr gute Wärmeleitfähigkeit sowie eine extrem hohe chemische Stabilität und hohe Härte aus. Für eine Rückseitenkontaktierung von GaN-Transistoren besteht also die Notwendigkeit, das Trägermaterial aus SiC sowie die darüber liegende GaN-Epitaxieschicht zu durchbohren, Für eine Strukturierung kamen bisher praktisch nur trockenchemische Ätzverfahren wie reaktives Ionenätzen in eigens dafür optimierten Hochleistungs-Plasmaätzreaktoren Frage. Typische Plasma-Ätzraten von SiC sind aber mit 1 µm/min sehr klein. Der Einsatz der Plasmaätztechnik setzt zudem die Herstellung und lithographische Strukturierung einer widerstandsfähigen Ätzmaske voraus.

Es ist bekannt, dass sich in Leiterplatten Vias durch den Einsatz von Lasern herstellen lassen. Bei diesen Technologien werden mit dem Laser Öffnungen in die Kupfer- und Dielektrika-Schichten gebohrt und diese dann metallisiert, um elektrische Verbindungen zwischen bestimmten Lagen herzustellen. Die unterschiedlichen Lasertechnologien basieren auf dem Einsatz von CO₂-Lasern, frequenzverdoppelten (grünen) YAG-Lasern, Excimerlasern und UV:YAG-Lasern.

Die Herstellung dieser Vias ist beispielsweise beschrieben in:
- L. W. Burgess: "Introducing Via-in-Pad Blind Via Technology to Any PCB Multilayer Fabricator." IPC Printed Circuits Expo 1997, March 9-13, 1997, San Jose, CA, S15-2.
- A. Cable: "Improvements in High Speed Laser Microvia Formation Using Solid State Nd:YAG UV Lasers." IPC Printed Circuits Expo 1997, March 9-13, 1997, San Jose, CA, S17-7.
- M.D. Owen: "Via drilling." In: J.F. Ready, D.F. Farson (Edtrs.): LIA Handbook of laser materials processing, Laser Institute of America, Magnolia Publishing (2001) 661-665.

Nach EP 0 926 723 A und US 4 964 212 A sind ebenfalls Verfahren zur Herstellung von Vias in Substraten bekannt. Herbei werden jeweils Sacklöcher von der Waferrückseite her in das Substrat gebohrt. Als Halbleitersubstrat wird Silicium genannt. In US 4 964 212 A wird ein gütegeschalteter Nd: YAG-Laser (Wellenlänge 1,06 µm) verwendet und auf US 4 437 109 verwiesen, in dem auch der Einsatz eines frequenzverdoppelten Nd: YAG-Lasers (Wellenlänge 0,53 µm) erwähnt wird. Auf die Wafervorderseite wird eine (Isolator-)Schicht aufgebracht, die als Laser-Ätzstopp dient, da sie die Laserstrahlung nicht absorbiert. Eine die Laserstrahlung absorbierende Metallschicht eines Kontaktes auf der Vorderseite würde sich hierbei verbieten.

Nach EP 0 926 723 A wird auf die Rückseite eine Schutzschicht aus Metall (Cr) aufgebracht, die die Laserstrahlung reflektiert. Die Laserbearbeitung erfolgt, nachdem die Chromschicht an den Bearbeitungsstellen geöffnet wird, so dass das Substrat durch die Laserstrahlung abgetragen werden kann. Hierfür ist eine lithographische Strukturierung der Rückseite erforderlich. Die Isolatorschicht darf sich nicht auf dem Lochboden abscheiden oder die Schicht muss später von der Vorderseite aus wieder entfernt werden (sonst würde bei der späteren Metallisierung kein elektrischer Kontakt zur Vorderseite entstehen). Das Verfahren ist damit sehr kompliziert und unwirtschaftlich.

US 2005/104 228 A1 befasst sich mit Methoden des Packaging von mikroelektronischen Bauelementen und der Herstellung von Vias und leitfähigen Verbindungen in Microchips. Es wird die Herstellung von vertikalen leitfähigen Verbindungen durch einen Chip mit integrierter Schaltung beschrieben (waferlevel packaging) für die Anwendung in Multichip-Stapeln. Auf dem Chip befindet sich ein "redistribution layer" (RDL) aus Leitbahnen, die mit einem Ende am Bond-Pad angeschlossen sind und von dort lateral wegführen (zu Lotkugeln) . Ziel ist es, übereinandergestapelte Chips elektrisch miteinander zu verbinden. Es wird nach der Herstellung der Leitbahnen eine Öffnung am und im Bond-Pad hergestellt, d. h. das Metall durch Ätzen vollständig entfernt. Später wird an dieser Stelle mit dem Laser von der Rückseite her ein Loch erzeugt. Der Laser wird mit Hilfe einer Mustererkennung in Bezug zum Bond-Pad justiert, durchbohrt den Chip an der hergestellten Öffnung im Metall, d. h. das Bond-Pad-Metall wird nicht durchbohrt. Passivierungsschichten schützen die Vorder- und Rückseite beim Laserprozess und dem nachfolgenden Reinigungsätzen. Die Herstellung der vertikalen elektrischen Verbindungen besteht aus zahlreichen Verfahrensschritten (Abscheidung von TiCL₄, TiN, Rückätzen, stromlose Ni-Abscheidung nach Oberflächenaktivierung durch Tauchen in HF:Pd, Metallfüllung durch Lot oder Galvanik), die den Gesamtprozess vergleichsweise komplex machen.

Für die Erzeugung von Mikro-Vias in Halbleiterwafern ist somit bisher keine effektive Methode auf der Grundlage einer Lasertechnologie verfügbar.

Der Erfindung liegt die Aufgabe zugrunde, ein effektives Verfahren zur Erzeugung von Mikro-Vias in Halbleiterwafern aus Materialien hoher Härte und chemischer Stabilität wie Siliciumcarbid, Saphir oder ähnlichem anzugeben.

Erfindungsgemäß wird die Aufgabe gelöst durch ein Verfahren mit den Merkmalen des Anspruchs 1. Zweckmäßige Ausgestaltungen sind Gegenstand der Unteransprüche.

Danach ist das Verfahren gekennzeichnet durch die folgenden Schritte:
- Aufbringen eines Schutzlackes auf die Wafer-Vorderseite
- Strukturieren des Schutzlacks auf der Wafer-Vorderseite so, dass die mit der Wafer-Rückseite zu verbindenden Kontakte frei werden
- Laserbohren von Durchgangslöchern an den Kontaktverbindungsstellen von der Wafer-Rückseite her durch das Halbleitersubstrat, die aktiven Schichten und die zu verbindenden Kontakte auf der Wafer-Vorderseite
- Reinigung des Wafers (Entfernen des Debris)
- Aufbringen einer Plattierbasis auf die Wafer-Rückseite und in die lasergebohrten Durchgangslöcher
- galvanischer Goldauftrag auf die metallisierte Wafer-Rückseite und die Durchgangslöcher
- Ablacken des Schutzlacks
- Aufbringen einer Antibenetzungsschicht im Bereich der Eintrittsöffnungen der Durchgangslöcher an der Wafer-Rückseite.

Die Reinigung eines SiC-Wafers erfolgt zweckmäßig nasschemisch mit gepufferter Flusssäure.

Für die Antibenetzungsschicht (Dewettingschicht) wird zweckmäßig Titan verwendet, das aufgesputtert werden kann.

Der Auftrag der Antibenetzungsschicht erfolgt zweckmäßig mit Hilfe einer Schattenmaske.

Als Laser eignet sich ein UV-Laser, bevorzugt ein frequenzverdreifachter Nd:YAG-Laser mit einer Wellenlänge von 355 nm.

Das Aufbringen der Plattierbasis in die Mikro-Vias kann mit mehreren Methoden erfolgen. Bevorzugt wird eine Schrägbedampfung, eine chemische Badabscheidung (stromlos) oder ein Aufsputtern sind ebenfalls möglich.

Das Verfahren hat den Vorteil, dass Mikro-Vias in harten und chemisch inerten Substratmaterialien mit wesentlich verringertem Zeitaufwand und mit hoher Präzision erzeugt werden können. Außerdem sind keine Ätzmasken erforderlich und es erfolgt kein Abdünnen der Substrate.

Die Erfindung soll anhand eines Ausführungsbeispiels näher erläutert werden. Die zugehörige schematische Zeichnung zeigt einen Wafer mit einem Transistoraufbau und den fertigen Mikro-Vias im Querschnitt.

Der Wafer besteht aus einem SiC-Substrat 1 von ca. 250 bis 400 µm Dicke, auf dem ein AlGaN/GaN-Schichtenstapel 2 von ca. 2 bis 3 µm Dicke epitaktisch aufgewachsen ist. Auf der Vorderseite des Wafers befinden sich auf dem Schichtenstapel 2 die Anschlusskontakte eines Transistors, nämlich ein Drain-Kontakt, ein Gate-Kontakt und ein Source-Kontakt 3. Das Potential des Source-Kontakts 3 muss auf die Rückseite (Masseelektrode) des Wafers zurückgeführt werden, was mit Hilfe eines Mikro-Vias 4 erfolgt, dessen Lochwände 5 metallisiert sind, so dass der Source-Kontakt 3 auf der Vorderseite mit der Masseelektrode auf der Rückseite des Wafers elektrisch verbunden wird.

Im Folgenden sollen die Prozessführung des erfindungsgemäßen Verfahrens und die erzielten Resultate beschrieben werden. Die fertig prozessierten GaN-Transistoren oder MMICs werden im Waferverbund mit den Mikro-Vias 4 versehen. Zunächst wird auf die Wafer-Vorderseite ein Schutzlack aufgebracht, um die Wafer bei den folgenden Verfahrensschritten zu schützen. Der Schutzlack wird in einem zweiten Schritt strukturiert, das heißt er erhält Öffnungen an den Kontakpads, die durchbohrt werden sollen. In einem dritten Schritt werden mit dem Laser Durchgangslöcher von der Rückseite des Wafers so gebohrt, dass die Lochaustrittsöffnungen mittig durch die Source-Kontakte 3 der Transistoren auf der Wafer-Vorderseite gehen. Lockere Partikel die sich beim Bohrprozess auf der Probe niederschlagen (Debris), werden anschließend in einem nasschemischen Reinigungsschritt entfernt. Hierzu eignet sich das Ätzen in gepufferter Flusssäure mit Ultraschall. Im Anschluss erfolgt das Aufbringen einer Plattierbasis in die Durchgangslöcher. Auf die Wafer-Rückseite wird dabei eine dünne Metallschicht 6 aufgedampft. Dabei wird die Probe schräg gehalten, um eine geschlossene Belegung der Lochwand 5 zu erzielen. Die durch die Metallschicht 6 erhaltene Plattierbasis wird anschließend durch eine ca. 5 µm dicke Goldschicht 7 galvanisch verstärkt. Auf diese Weise wird eine elektrische Verbindung von der einen Waferseite zur anderen Seite mit einer geschlossenen Goldschicht 7 hergestellt.

Mikroskopaufnahmen belegen, dass die Durchgangslöcher mitten durch die Kontaktpads gehen. Im Querschnitt durch eine Laserbohrung ist erkennbar, dass die Lochwand 5 vollständig metallisiert ist, das heißt, dass die Metallschicht 6/Goldschicht 7 von der Wafer-Rückseite bis zum Kontaktpad geschlossen ist. Die realisierten Mikro-Vias 4 (Hohlnieten-Vias) haben ein Aspektverhältnis von 4.

Nach dem Metallisieren erfolgt in einem weiteren Prozessschritt das Ablacken des Schutzlackes.

Beim Löten der später aus dem Wafer hergestellten Bauelemente muss verhindert werden, dass sich Lot fontänenartig durch die Mikro-Vias 4 hindurch zieht und sich Lotspritzer und -kügelchen auf der Bauelementevorderseite niederschlagen. Dazu wird an den Via-Eintrittsöffnungen auf der Rückseite eine Antibenetzungsschicht 8 aus Titan aufgebracht. Eine 100 nm dünne Titanschicht, die auf die vorhandene Goldschicht 7 gesputtert wird, verhindert später das fontänenartige Durchtreten von Lot bis zur Bauelementevorderseite. Die Antibenetzungsschicht 8 wird mit Hilfe einer Schattenmaske strukturiert auf den Wafer aufgebracht. Die Schattenmaske besteht aus einer 0.1 mm dicken Metallfolie, in die mit einem Laser Öffnungen gebohrt werden. Das Layout der Öffnungen in der Metallfolie entspricht der Anordnung der Mikro-Vias 4 auf dem Wafer. Die Durchmesser der Öffnungen in der Schattenmaske sind etwas größer als der Eintrittsdurchmesser der Mikro-Vias 4 auf der Wafer-Rückseite, so dass sich ein etwa 40 µm breiter Titan-Ring um die Via-Eintrittsöffnungen ausbildet. Mit Hilfe von je vier zusätzlichen Durchgangsbohrungen am Rand von Schattenmaske und Wafer werden beide Teile mittels Passstiften zueinander justiert, das heißt deckungsgleich gebracht.

Es ist anzumerken, dass das Ablacken des Schutzlacks auch erst nach der Abscheidung der Antibenetzungsschicht 8 (Titan-Dewettingschicht) erfolgen kann.

Im Hinblick auf Abtragsrate, Flexibilität und Zuverlässigkeit ist ein frequenzverdreifachter Nd:YAG-Laser für die Bearbeitung des sehr harten und chemisch inerten SiC gut geeignet. Dieser Laser liefert Nanosekundenpulse mit hoher Energie im ultravioletten Spektralbereich bei einer Wellenlänge von 355 nm mit Pulsfrequenzen von bis zu 100 kHz. Der Laserstrahl wird durch Kombination einer CNC-gesteuerten Bewegung des Probentisches und der Strahlablenkung mit einem Galvo-Scanner mikrometergenau bewegt. Mit Hilfe einer Bilderkennung und eines hochgenauen luftgelagerten XY-Kreuztisches kann der Laserstrahl mit einer Genauigkeit von ±1 µm in bezug auf vorhandene Strukturen auf dem Werkstück positioniert werden. Diese Präzision wird auch erreicht, wenn die Laserstrukturierung auf der Rückseite erfolgt und sich die Justagemarken auf der (untenliegenden) Vorderseite befinden.

Zur Herstellung von 100 µm weiten Durchgangsbohrungen mit möglichst glatten Wänden wird der Laserstrahl, der einen Durchmesser von 15-20 µm hat, zweckmäßig auf der Probe bewegt, beispielsweise kreisförmig.

Es wurde ein automatisiertes Bohrverfahren verwendet, bei dem die jeweilige Bearbeitungsstelle der Probe durch präzises Verfahren des Probentisches mikrometergenau unter dem Strahlaustritt positioniert wird und der Laserstrahl dann durch ein Spiegelsystem (Galvo-Scanner) schnell auf dem Werkstück bewegt wird, wobei 250-450 µm dickes SiC verwendet wurde. Im Rasterelektronenmikroskop lässt sich gut erkennen, dass die lasergebohrten Löcher leicht konisch sind und sich eine glatte Wand erzeugen lässt.

Widerstandsmessungen an einer SiC-Probe belegen, dass sich eine niederohmige Verbindung zwischen Vorder- und Rückseite herstellen lässt. Dazu wurde eine Probe zunächst auf einer Seite ganzflächig mit einer 5 µm dicken Goldschicht metallisiert. Von der anderen Seite wurde dann eine Matrix von Löchern lasergebohrt. Der Lochabstand betrug 250 µm bzw. 500 µm. Anschließend erfolgte wie oben beschrieben die Metallisierung dieser Fläche einschließlich der Löcher. Vor der Messung des Widerstandes durch ein einzelnes Loch mussten die einzelnen Löcher elektrisch voneinander separiert werden. Dazu wurde die Goldschicht geritzt, um 250x250 µm² bzw. 500x500 µm² große Felder mit je einem Durchgangs-Via zu erhalten.

Es wurde eine Kontaktierung durch die SiC-Probe hindurch mit guter Reproduzierbarkeit und sehr homogen realisiert. Die Widerstandswerte liegen bei 25-28 mΩ. Der Mittelwert über die 207 Mikro-Vias liegt bei 27±0.5 mΩ.

In Tests an aufgebauten Transistoren verschiedenen Typs wurde die Funktionstüchtigkeit der Bauelemente nachgewiesen. Anhand der Transistor-Kennlinien wurde der Nachweis für die erfolgreiche Implementierung des Laserbohrens von Mikro-Vias in die GaN-Prozesstechnologie geführt.

Die technologischen Untersuchungen zeigen die Machbarkeit von lasergebohrten Mikro-Vias durch einkristallines SiC-Wafermaterial, für GaN-Hochleistungs-Feldeffekttransistoren.

Es konnte nachgewiesen werden, dass sich die Lasermikrostrukturierung in die Bauelemente-Prozesstechnologie erfolgreich implementieren lässt.

Voraussetzung für die Anwendung der Laser-Mikrobearbeitung in der Prozessierung von Halbleiter-Wafern ist eine hohe Positioniergenauigkeit des Strahlmittelpunktes von ± 1µm und besser. Diese Genauigkeit bezieht sich auf die Strahlpositionierung relativ zu vorhandenen Bauelementestrukturen und muss sowohl bei der Bearbeitung von der Vorderseite wie auch von der Rückseite erzielt werden.

### Bezugszeichenliste

- 1: SiC-Substrat
- 2: AlGaN/GaN-Schichtenstapel
- 3: Source-Kontakt
- 4: Mikro-Via
- 5: Lochwand
- 6: Metallschicht
- 7: Goldschicht
- 8: Antibenetzungsschicht

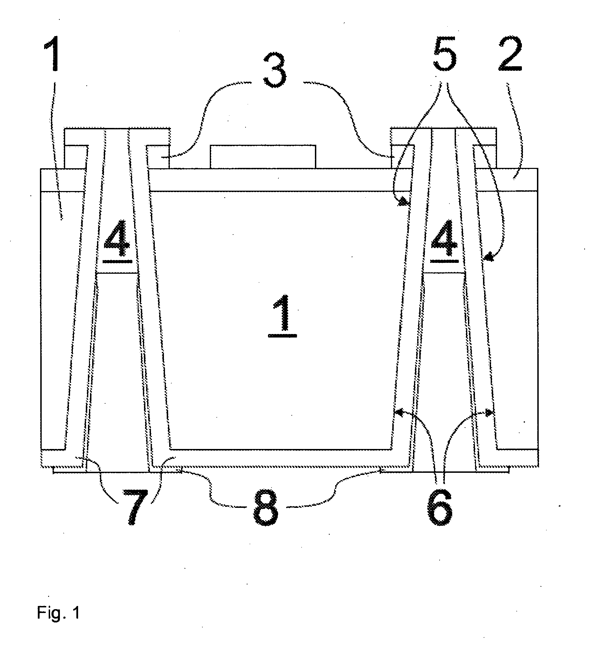

## Patentansprüche

1. Verfahren zur Erzeugung von vertikalen elektrischen Kontaktverbindungen in Halbleiter-Wafern zur Herstellung von Halbleiter-Bauelementen, das heißt von Kontakten (3) auf der Wafer-Vorderseite durch den Halbleiter-Wafer hindurch zur Wafer-Rückseite,
**gekennzeichnet durch** die folgenden Schritte:
- Aufbringen eines Schutzlackes auf die Wafer-Vorderseite
- Strukturieren des Schutzlacks auf der Wafer-Vorderseite so, dass die mit der Wafer-Rückseite zu verbindenden Kontakte frei werden
- Laserbohren von Durchgangslöchern (4) an den Kontaktverbindungsstellen von der Wafer-Rückseite her **durch** das Halbleitersubstrat (1), die aktiven Schichten und die zu verbindenden Kontakte (3) auf der Wafer-Vorderseite
- Reinigung des Wafers
- Aufbringen einer Plattierbasis (6) auf die Wafer-Rückseite und in die lasergebohrten Durchgangslöcher (4)
- galvanischer Goldauftrag (7) auf die metallisierte Wafer-Rückseite und die Durchgangslöcher (4)
- wobei diese Verfahrensschritte in der der voran stehenden Reihenfolge nacheinander abgearbeitet werden und
- Ablacken des Schutzlacks
- Aufbringen einer Antibenetzungsschicht (8) im Bereich der Eintrittsöffnungen der Durchgangslöcher (4) an der Wafer-Rückseite.

2. Verfahren nach Anspruch 1, **dadurch gekennzeichnet, dass** die Reinigung nasschemisch mittels gepufferter Flusssäure erfolgt.

3. Verfahren nach Anspruch 1 oder 2, **dadurch gekennzeichnet, dass**
für die Antibenetzungsschicht (8) Titan verwendet wird.

4. Verfahren nach einem der Ansprüche 1 bis 3, **dadurch gekennzeichnet,**
**dass** die Antibenetzungsschicht (8) aufgesputtert wird.

5. Verfahren nach einem der vorhergehenden Ansprüche, **dadurch gekennzeichnet, dass**
der Auftrag der Antibenetzungsschicht (8) mit Hilfe einer Schattenmaske erfolgt.

6. Verfahren nach einem der vorhergehenden Ansprüche, **dadurch gekennzeichnet, dass**
zum Laserbohren ein UV-Laser verwendet wird.

7. Verfahren nach einem der vorhergehenden Ansprüche, **dadurch gekennzeichnet, dass**
der Auftrag der Plattierbasis (6) durch Schrägaufdampfen erfolgt.

8. Verfahren nach einem der Ansprüche 1 bis 6, **dadurch gekennzeichnet, dass**
der Auftrag der Plattierbasis (6) durch Sputtern erfolgt.

9. Verfahren nach einem der Ansprüche 1 bis 6, **dadurch gekennzeichnet, dass**
der Auftrag der Plattierbasis (6) durch chemische Badabscheidung erfolgt.

10. Verfahren nach einem der vorhergehenden Ansprüche, **dadurch gekennzeichnet, dass**
zum Laserbohren ein Laser benutzt wird, dessen Strahl kleiner ist als die Querschnittsfläche des zu erzeugenden Durchgangsloches (4), wobei der Strahl über den Bereich des Durchgangsloches (4) bewegt wird.

## Claims

1. A method for producing vertical electrical contact connections in semiconductor wafers for the manufacture of semiconductor devices, i.e. from contacts (3) on the wafer front side, passing through the semiconductor wafer, to the wafer back side,
**characterized by** the following steps:
- applying a protective varnish to the wafer front side,
- structuring the protective varnish on the wafer front side in such a manner that the contacts to be connected to the wafer back side are exposed,
- laser drilling through-holes (4) at the contact connection points, from the wafer back side, passing through the semiconductor substrate (1), the active layers, and the contacts (3) to be connected on the wafer front side,
- cleaning the wafer,
- applying a plating base (6) onto the wafer back side and into the laser drilled through-holes (4),
- gold plating (7) the metallized wafer back side and the through-holes (4),
- said method steps being carried out one after the other in the order indicated above,
- removing the protective varnish,
- applying a dewetting layer (8) in the area of the openings of the through-holes (4) on the wafer back side.

2. A method according to claim 1, **characterized in that** said cleaning is done by a wet chemical process using buffered hydrofluoric acid.

3. A method according to claim 1 or 2, **characterized in that** titanium is used for the dewetting layer (8).

4. A method according to any one of claims 1 to 3, **characterized in that**
the dewetting layer (8) is applied by sputtering.

5. A method according to any one of the preceding claims, **characterized in that**
the dewetting layer (8) is applied using a shadow mask.

6. A method according to any one of the preceding claims, **characterized in that**
laser drilling is done using a UV laser.

7. A method according to any one of the preceding claims, **characterized in that**
the plating base (6) is applied by oblique vapour-deposition.

8. A method according to any one of claims 1 to 6, **characterized in that**
the plating base (6) is applied by sputtering.

9. A method according to any one of claims 1 to 6, **characterized in that**
the plating base (6) is applied by chemical bath deposition.

10. A method according to any one of the preceding claims, **characterized in that**
laser drilling is done using a laser whose beam is smaller than the cross-sectional area of the through-hole (4) to be produced, which beam is moved over the area of the through-hole (4).

## Revendications

1. Procédé pour la réalisation de connexions de contact électriques verticales dans des wafers de semi-conducteurs, pour la fabrication de composants de semi-conducteurs, c'est-à-dire de contacts (3) sur la face avant du wafer à travers le wafer de semi-conducteur jusqu'à la face arrière du wafer, **caractérisé par** les étapes suivantes :
- application d'une laque de protection sur la face avant du wafer
- structuration de la laque de protection sur la face avant du wafer de telle sorte que les contacts devant être reliés avec la face arrière du wafer soient libérés
- perçage laser de trous traversants (4) aux emplacements de connexion de contact, de la face arrière du wafer à travers le substrat semi-conducteur (1), les couches actives et les contacts (3) devant être connectés sur la face avant du wafer
- nettoyage du wafer
- pose d'une base de plaquage (6) sur la face arrière du wafer et dans les trous traversants (4) percés au laser
- dépôt d'or galvanisé (7) sur la face arrière métallisée du wafer et dans les trous traversants (4)
- ces étapes de procédé étant effectuées l'une après l'autre dans l'ordre ci-dessus et
- retrait de la laque de protection
- application d'une couche anti-humidification (8) dans la zone des orifices d'entrée des trous traversants (4) sur la face arrière du wafer.

2. Procédé selon la revendication 1, **caractérisé en ce que**
le nettoyage est effectué par voie humide, au moyen d'acide fluorhydrique tamponné.

3. Procédé selon la revendication 1 ou 2, **caractérisé en ce que**
du titane est utilisé pour la couche anti-humidification (8).

4. Procédé selon l'une des revendications 1 à 3, **caractérisé en ce que** la couche anti-humidification (8) est déposée par pulvérisation cathodique.

5. Procédé selon l'une des revendications précédentes, **caractérisé en ce que**
le dépôt de la couche anti-humidification (8) est effectué à l'aide d'un masque perforé.

6. Procédé selon l'une des revendications précédentes, **caractérisé en ce qu'**
un laser UV est employé pour le perçage laser.

7. Procédé selon l'une des revendications précédentes, **caractérisé en ce que**
le dépôt de la base de plaquage (6) est effectué par évaporation oblique.

8. Procédé selon l'une des revendications 1 à 6, **caractérisé en ce que**
le dépôt de la base de plaquage (6) est effectué par pulvérisation cathodique.

9. Procédé selon l'une des revendications 1 à 6, **caractérisé en ce que**
le dépôt de la base de plaquage (6) est effectué par dépôt en bain chimique.

10. Procédé selon l'une des revendications précédentes, **caractérisé en ce que**
pour le perçage laser, un laser est utilisé dont le rayon est inférieur à la surface de section du trou traversant (4) devant être réalisé, le rayon étant déplacé au-dessus de la zone du trou traversant (4).
